Europäisches Patentamt

European Patent Office

Office européen des brevets

(11) Publication number : **0 493 106 A2**

(12) **EUROPEAN PATENT APPLICATION**

(21) Application number : 91312006.9

(22) Date of filing : 23.12.91

(51) Int. Cl.⁵ : **H05K 3/32**

(30) Priority : **27.12.90 US 634642**

(43) Date of publication of application :
**01.07.92 Bulletin 92/27**

(84) Designated Contracting States :
**DE FR GB**

(71) Applicant : **International Business Machines
Corporation
Old Orchard Road
Armonk, N.Y. 10504 (US)**

(72) Inventor : **Kelly-Mahaffey, William Larry
2805 Silverway
Austin, Texas 78757 (US)**
Inventor : **Stafford, James Michael
1060 Red Bus Lane
Round Rock, Texas 78664 (US)**

(74) Representative : **Mitchell, Allan Edmund et al
IBM United Kingdom Limited Intellectual
Property Department Hursley Park
Winchester Hampshire SO21 2JN (GB)**

(54) **Method of locating objects.**

(57)    In a method for determining the presence and position of fiducials on the surface of a printed circuit substrate 6 in gray level images to sub-pixel accuracy, summation profile technique is used to decrease the amount of computation required and thereby increase throughput by enabling real time operation in a total component placement system. A robot arm 3 has an end effector 2 carrying a component 4 to be placed on a substrate 6. The substrate 6 is illuminated by a light source 10. A camera 8, carrried by the arm 3 senses the substrate 6 to obtain gray level pixel data which is transmitted through a frame grabber 22 to a vision processor 20. This latter determines, from data received, the presence or absence of a fiducial, finds the approximate centre thereof, and calculates the centre to sub-pixel accuracy.

FIG. 1

The present invention relates to methods of locating objects and particularly to computer vision techniques for locating objects in a field of view. More specifically, but not exclusively, it relates to finding locations on a substrate at which electronic components are to be placed and in controlling other hardware in a total placement system.

Great accuracy is required in placing electronic components on printed circuit substrates for subsequent bonding thereto. This requirement for accuracy is particularly significant when extremely fine pitch components are to be placed. It is known in the prior art to utilise computer vision techniques for such placement. However, it is conventional to perform extensive manipulation of all pixels in a camera field of view to achieve accuracy when placing surface mountable components.

A fiducial is a piece of artwork on a printed circuit substrate whose distance from all other artwork is known. As a fiducial can be located automatically within an image by means of a vision system, the image of the fiducial space coordinates may be mapped to real world coordinates to allow automatic derivation of real world coordinates for other parts of the substrate artwork. This information is used to control a robot and other motive means for manipulating a printed circuit board and the components to be placed thereon.

It is known to find objects within an image using gray level techniques but extensive manipulation of all pixels in the search window is traditionally necessary. Some increase in processing time may be achieved by embedding primitive operations in hardware. However, such an arrangement alters the scale of timings only, not their order. In either hardware or software the order of search is N x N, i.e. two dimensional.

These techniques for finding fiducials as part of the process for aligning components accurately on placement sites are described in the literature. IBM Technical Disclosure Bulletin Volume 31, Number 10, March 1989, pp. 222, discloses the use of vision techniques for calibrating a printed circuit board to a robot coordinate system using a camera and fiducials on the board as well as footprint fiducials.

IBM Technical Disclosure Bulletin Volume 32, Number 7, December 1989, pp. 66, also discloses the use of a vision system for viewing board fiducials at the component footprint in preparation for a surface mount component placement.

IBM Technical Disclosure Bulletin Volume 30, Number 1, June 1987, pp. 228, discloses the use of computer vision and locating board fiducials for accurate component placement.

IBM Technical Disclosure Bulletin Volume 32, Number 8A, January 1990, pp. 5, relates to the use of vision techniques and determining fiducial mark location prior to component placement. It is desirable to use vision processing to locate fiducials with the highest possible degree of accuracy while minimising the amount of time and computational resources required.

The present invention represents an improvement over the prior art by simplifying the process for or finding fiducials. The present invention uses summation profiles to find fiducials on a printed circuit board, which leads to a great reduction in the amount of pixel data to be analysed.

As is frequently the case, fiducials are circular in configuration and the present invention takes advantage of the symmetry of circular and convex polygonal fiducials to reduce the two-dimensional information in a search window to two one-dimensional summation profiles which, abstracted, represent the average value of pixels along rows and columns in the search window.

A camera captures gray level images which are digitised and stored in an array of pixel values in system memory. Summation data is obtained by summing all pixels in each row and column.

Then the edges of the fiducial in the two one-dimensional profiles are found and ordered to determine the approximate centre of the fiducial. After the approximate centre is found, a similar method of edge detection is performed on rows and columns of pixels in the neighbourhood of the approximate centre in order to determine the centre to sub-pixel accuracy.

Thus, N x N computation is restricted to producing summation profiles which can be processed quickly as more complex processing is of the order N. Summation profiles enable the finding of the approximate centre of a fiducial and the approximate centre is used to locate a very small order subset of two dimensional data which is processed to find the centre of the fiducial to sub-pixel accuracy.

Once the centre of a fiducial is found to sub-pixel accuracy, that information is passed in a conventional manner to downstream system controls, e.g., for guiding robotic placement of a component.

The scope of the invention is defined by the appended claims; and how it can be carried into effect is described with reference to the accompanying drawings in which:

Fig. 1 is the schematic diagram of a placement system in which the present invention is used;

Fig. 2 is a plan view of a portion of the surface of a printed circuit substrate;

Fig. 3 shows an idealised summation profile;

Fig. 4 shows a summation profile;

Fig. 5 graphically illustrates screening for finding fiducial edges;

Fig. 6 graphically illustrates finding the exact centre of a fiducial; and

Fig. 7 is a flowchart describing the logic performed in finding fiducial centres.

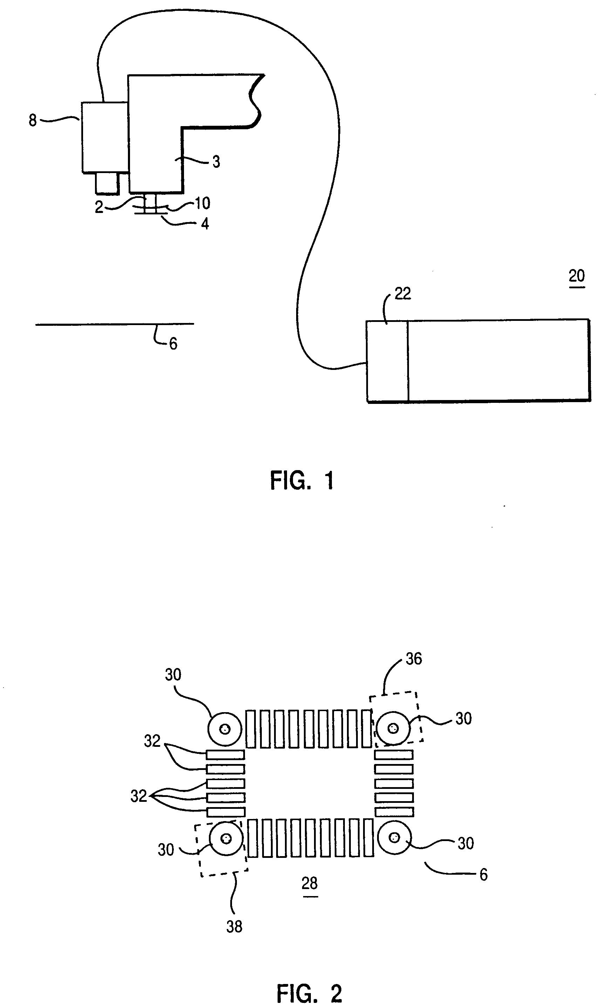

Robot arm 3 (Fig. 1) includes an end effector 2 carrying a component 4 to be placed on a substrate 6. A camera 8 is borne on robot arm 3 so as to look downwardly at printed circuit substrate 6. Camera 8 may be a 480 x 512 sensor array for obtaining gray level pixel data. A circular light source 10 is mounted on the robot end effector 2 to illuminate substrate 6. Vision processor 20 includes a frame grabber 22 for accepting analog input from camera 8, converting the data to digital form and storing it. Whilst frame grabber 22 is shown for illustrative purposes, any apparatus for acquiring digitised gray level image data is suitable.

At a site 28 (Fig. 2) for a component on the surface of printed circuit substrate 6, four fiducials 30 define the position of the site and of metallized pads 32 on which leads of the surface mount component will be mounted. Apparatus calibration procedures include establishing the number of pixels per millimetre in both the X and Y directions. Substrate artwork specifications are also known so that predetermination of a search window for camera 8 is facilitated. Such windows are represented generally at 36 and 38. Determination of the presence and location of the fiducials located by search windows 36 and 38, provides sufficient information to control the placement apparatus.

The method for such determination according to the present invention includes two phases. In the first phase, the presence/absence of a fiducial is determined and, if present, the approximate centre of the fiducial is determined. In the second phase, the location of the approximate centre of the fiducial is used in finding the centre of the fiducial to sub-pixel accuracy.

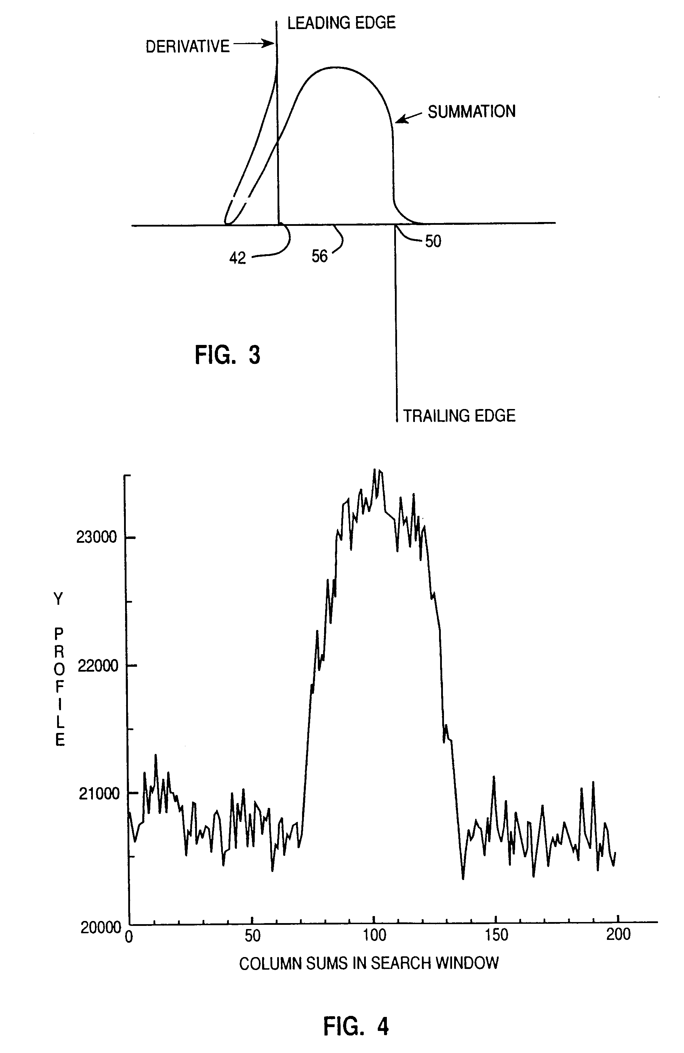

Summation profiles of the search window are taken in the X and Y directions. High and low first differences in the profiles are deemed to correspond to the leading and trailing edges of the fiducial. Fig. 3 shows an idealised summation profile for a fiducial 30. Leading edge 42 is found easily by taking the high first. Similarly trailing edge 50 is found by the low first. Then the centre point 56 is the midpoint therebetween. If the window is cluttered by objects other than the fiducial, first differences are screened to find the best match with the fiducial diameter. The presence of the fiducial is rejected if no exactly potential match for the diameter is found.

The surface mount component to be placed is a TAB device having leads with dimensions in the 40 to 12 mil range. The diameter size for a fiducial for leads in this range is typically 1.016 mn (0.040 in). The screening parameters are chosen based upon the expected contrast between the fiducial and the printed circuit board surface. However those having skill in the art will realise that other screening parameters corresponding to different printed circuit board/fiducial contrast values may be used.

A summation profile for a typical fiducial in the Y direction is shown in Fig. 4. The corresponding summation profile in the X direction would look very much like that in Fig. 4.

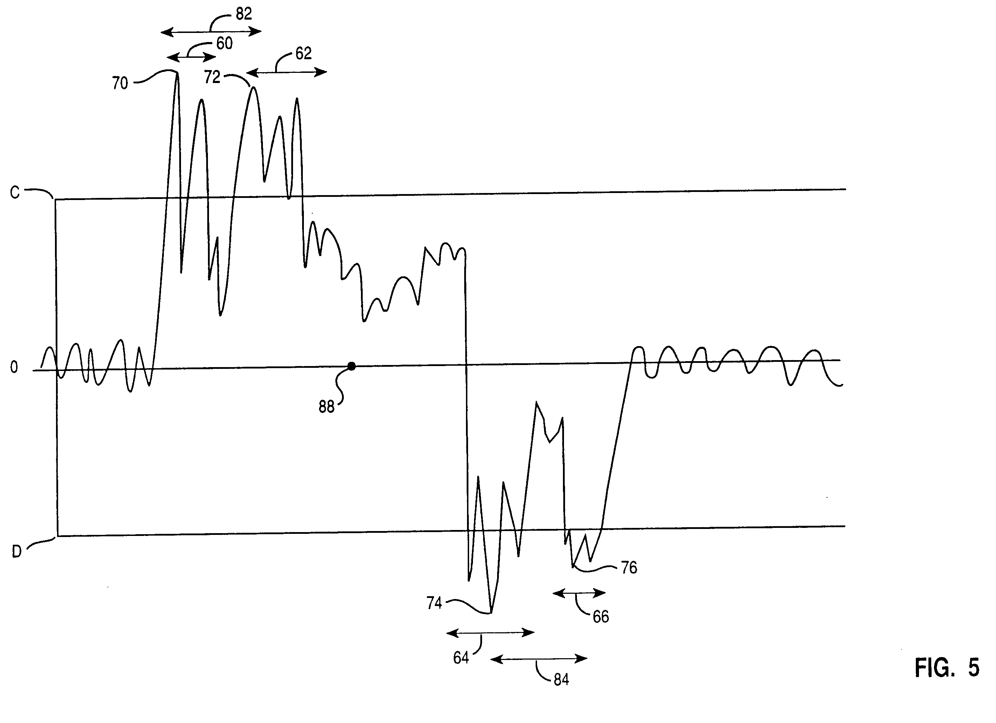

Fig. 5 shows a graph of the first differences of a summation profile similar to that in Fig. 4. The screening parameters have been selected as 1.85 sigma from the mean. Lines C and D represent the upper and lower screening levels.

High values are those greater than 1.85 sigma from the mean. If no peaks meet this criterion, then the maximum peak is chosen. Similarly, low values are those below -1.85 sigma from the mean or the minimum value peak if it is above -1.85 sigma from the mean.

For contiguous runs 60, 62 of high values and runs 64, 66 of low values meeting these criteria, the maxi values among highs and the minimum value among lows are chosen as shown at 70 and 72, and 74 and 76.

All combinations of chosen high and lows whose distance apart is within one-quarter of the expected fiducial diameter as represented by arrows 82, 84 of a fiducial are selected. In this case, high peaks 70 and 72 and low peaks 74 and 76 meet these criteria.

Any pairs of combinations for which both the leading and trailing edges of the two pairs are no further apart than one-quarter of the diameter of the fiducial are assumed to be the same candidate and the pair whose size is closest to the expected diameter is selected.

If after the above screenings have been applied, exactly one candidate pair of high and low peaks is found, its approximate centre is deemed to be half way between the two peak valley pairs as shown at 88. If not exactly one candidate remains, then the fiducial is deemed absent and rejected.

In the next phase of processing, the X, Y coordinates of the exact centre of the fiducial are found. Small arrays of pixels from frame grabber 22 are examined. First, N rows of pixels centred at the approximate Y location are considered in order to find the X coordinate.

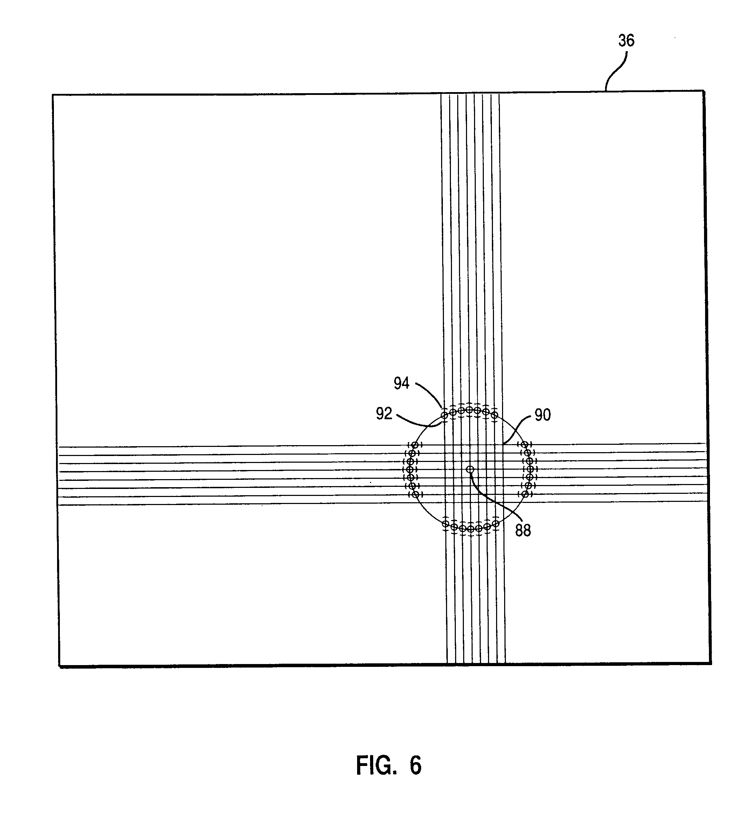

As shown in Fig. 6, seven rows and seven columns surrounding the approximate centre 88 of the fiducial are considered as shown at 90. Bounding concentric arcs 92 and 94 are computed by measuring from 0.75 to 1.25 times fiducial radius, in that direction, on both sides of the approximate X and Y centre. Thus the amount of two dimensional data to be retrieved from frame grabber 22 (Fig. 1) is extremely small.

Once the pixel data is retrieved, first differences are taken by subtracting adjacent values along each row or column, then using the first differences so calculated, edges within those ranges are determined.

The boundaries of the fiducial whose centre is halfway in between are determined. The average of the centres found in this manner is the value of the X coordinate of the centre of fiducial 30 to sub-pixel accuracy.

In a similar manner, the Y coordinate of the exact centre is determined. First differences along each column in the bounding arcs described at points 0.75 to 1.25 times the known radius of the fiducial on both sides of the approximate Y centre are taken. Again, using first those differences enables the edges within those ranges are found.

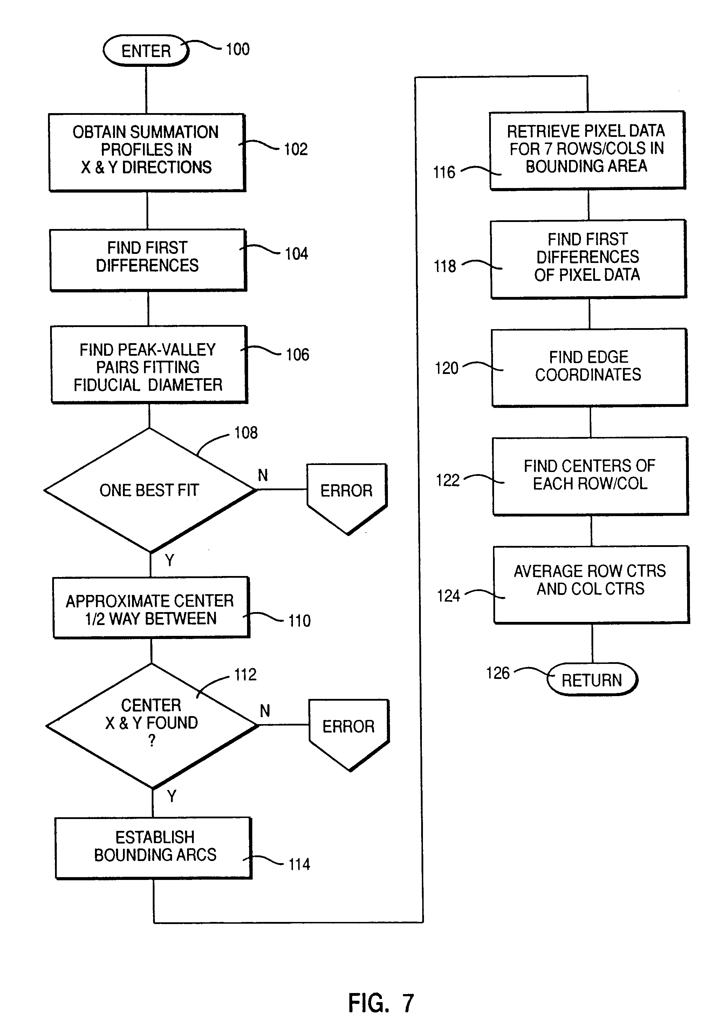

Refer now to Fig. 7 which is a flow chart of logic followed in vision processor 20. Logic is entered at terminal 100 after digitised pixel data from window 36 is stored. In step 102, summation profiles in both X and Y are obtained, that is, within the area of interest, all the pixel values in rows are summed and all the pixel values in columns are summed, to yield two one-dimensional arrays.

First differences are found in step 104, by subtracting adjacent valleys from adjacent peaks. Then, the first differences so found are screened in step 106 to yield peak-valley pairs prior to comparing the peak valley pairs with known fiducial X and Y diameters in step 108 and finding the best match. If no best match is found in step 108, an error condition is returned. Otherwise, the approximate centre is then calculated in step 110 by choosing the point halfway between the peak-valley pair chosen.

As it is necessary to find both X and Y summation profiles and to derive approximate centres therefrom, it is determined in step 112 whether both an X centre and a Y centre have been found. If not, an error condition is returned.

When the X and Y coordinates of the approximate centre have been successfully found, the logic is ready to begin finding the X and Y coordinates of the exact centre of the fiducial to sub-pixel accuracy. In the first step 114 in that process, two concentric bounding arcs are established, an inner bounding arc of 0.75 times the fiducial radius in the appropriate direction on either side of the approximate centre found above, and an outer bounding arc 1.25 times the fiducial radius from the approximate centre in both directions. Pixels are not square, so that the bounding arcs may not describe two concentric circles.

Up to this point all calculations have been performed on the one dimensional summation profiles due to the benefit in throughput achieved by minimising the number of calculations to be performed. While our process for finding the exact centre requires manipulation of two dimensional arrays, these are very, very small, being the pixels within the concentric bounding arcs at the four locations, as shown in Fig. 6. Thus in step 116, those pixel arrays are retrieved from frame grabber 22 (Fig. 1). In step 118, first differences of pixel data are found. This is followed by finding the edge coordinates within the first differences in step 120. For each row or column, a centre is calculated in step 122, and in step 124, all row centres are averaged and all column centres are averaged to provide the exact centre. The process then returns in step 126.

Two kinds of fiducials can be handled by simple profile methods. The first is a fiducial which has been shaved during the cleaning process. This causes its edge to to appear as a ramp in the image. since the entire ramp causes responses in the first derivative, the pixel which is furthermost from the centre of the fiducial and closest to the background in intensity is located as the edge of the fiducial. The second type of fiducial is unabraded, which creates a very sharp edge in its profile. Here the strongest response in the first derivative is the location of the edge.

Differentials in etching and similar processes cause some fiducials to appear as two concentric circles resembling in the currency of the United States of America a dime stacked on a nickel. Empirically, has been discovered that the edge of the smaller inner circle produces a response in the first derivative which is approximately twice that of the outer circle. To find the edge of the fiducial, the edge of the inner circle is found first, and then first derivative responses are searched for towards the outside, until they fall below 45% of that of the inner circle.

What follows is a Pseudo code description of our technique for finding the exact centre of a fiducial.

Block 0:   Find Fiducial:

If the fiducial is in the region of interest:
then,
        Block 1 – Find the approximate centre of the fiducial.
        If the approximate centre is found:
then,
        Block 2 –  Find the centre to sub-pixel accuracy.

Block 1:   Find the Approximate Centre of the Fiducial:

Iteratively find the approximate centre, first in the Y direction,
second in the X direction:

        Obtain a summation profile in this direction.

        Find first differences of the summation profile.

        Using the first differences:
                Block 1A – find the left and right margins of the fiducial
                profile.

        If exactly one pair of left and right margins fitting the
        fiducial diameter in this direction is found:
        then
                The approximate centre of the fiducial is halfway between
                the margins.
        Else the fiducial does not exist.

Block 1A:   Find the Left and Right Margins of the
            Fiducial Profile:

Find the average, sigma, maximum, and minimum of the first
differences.

Using the average, sigma, maximum, and minimum, determine the screening envelope of differences to be considered.

Excluding peaks and valleys of the first differences which are inside the screening envelope:

    Block 1A1 - find candidates for leading and right margins of the fiducial.

If any candidates are found:

then,

    From the candidates found:

        Block 1A2 - find exactly one pair of left and right margins whose distance apart is:

        * closest to the size of the expected diameter

        * within ± 1/4 of the expected diameter.

    If not exactly one pair is found:

    then,

        The left and right margins do not exist.

**Block 1A1:**   <u>Find Candidates for Left and Right Margins</u>

            <u>of the Fiducial Profile</u>:

Iteratively examine each first difference:

    if a first difference value is outside the screening envelope:

    then,

        Find all first differences which are outside the envelope and connected through a chain of immediate adjacencies.

        If the fiducial is lighter than its background:

        then,

            For left margins, the maximum value of such a chain is a candidate.

            For right margins, the minimum value of such a chain is a candidate.

        Else

For left margins, the minimum value of such a chain is a candidate.

For right margins, the maximum value of such a chain is a candidate.

Block 1A2:   Find Exactly One Pair of Left and Right Margins:

Iteratively examine all pairs <a,b> of the set of left margin candidates, (lmc), and the set of right margin candidates, (rmc), where a is an element of lmc and b is an element of rmc:

    if the distance between a and b, (dis(a,b)), is >

        0.75 expected diameter

           and

        dis(a,b) < 1.25 expected diameter:

    then

        add <a,b> to the set of chosen pairs, C.   (C = C + {<a,b>})

From the set of chosen pairs, C exclude equivalent pairs:

    for all pairs of left and right margins <a,b> in the set of chosen pairs C, compare <a,b> with all pairs of left and right margins <c,d> in the set (C - {<a,b>}), where a and c are left margins and b and d are right margins:

        if dis(a,c) < 1/4 expected diameter and

          dis(b,d) < 1/4 expected diameter:

        then

           <a,b> is equivalent to <c,d>

           if (expected diameter - dis(a,b)) <

             (expected diameter - dis(c,d))

           then

             <a,b> is a better fit to the

             expected diameter than <c,d>

             discard <c,d>: C = C - {<c,d>}

           else

             <c,d> is a better fit to the

```
                     expected diameter than <a,b>
                     discard <a,b>: C = C - {<a,b>}


    if after completion of the above iteration, there exists
    exactly one pair <a,b> in the set C:
    then
            a is the left margin of the fiducial profile.
            b is the right margin of the fiducial profile.
    else
            The left and right margins of the fiducial profile do not
            exist.
```

Block 2:   Find the Centre to Sub-pixel Accuracy:

```
    Iteratively find the centre to sub-pixel accuracy, first in the Y
    direction, second in the X direction:
            Determine the ranges of pixels to be searched for the left/top
            and right/bottom edges of the fiducial:
                Left/top range is:
                    approximate centre - 1.25 x radius to
                    approximate centre - 0.75 x radius
                Right/bottom range is:
                    approximate centre + 0.75 x radius to
                    approximate centre + 1.25 x radius


    if finding the Y centre:
    then
            Iteratively treat columns from -n to +n about the X
            approximate centre:
    else finding the Y centre:
    then
            iteratively treat columns from -n to +n about the X
            approximate centre:
    else finding the X centre:
            iteratively treat rows from -n to +n about the Y
            approximate centre:
```

Read the pixels in a row or column.

[For purposes of this description, the number of rows or columns to be examined for sub-pixel accuracy is RC and n = integer part of RC/2. In examining RC rows, n rows above the approximate centre row are looked at, n rows below the approximate centre row are looked at, and the approximate centre row is looked at, 2n+1. In this embodiment RC = 7 shown in Fig. 6. Columns are handled likewise.]

Take the differences within the determined ranges.

Using the first differences, find the left/top and right/bottom edge coordinates.

The centre of the fiducial within the row or column profile is half way in between the two edge coordinates.

The centre to sub-pixel accuracy is the average of the 2n+1 row or column centres.

While the subject invention has been described having reference to a particular preferred embodiment, various changes including those above mentioned in form and detail may be made without departing from the scope of the invention as claimed.

Methods and apparatus for visual inspection of components prior to placement are described and claimed in EP -A- filed contemporaneously with this application and based upon US SN 07/634,675.

## Claims

1. A method for locating a circular or symmetrical convex polygonal fiducial of known dimensions on a circuit substrate comprising the steps of: determining fiducial presence, finding approximate fiducial centre, and calculating fiducial centre to sub-pixel accuracy.

2. A method according to Claim 1, wherein the determining step comprises: acquiring a two dimensional digitised image array, selecting a subarray representing a predetermined area within which a fiducial is expected, calculating summation profiles of rows and columns in the selected subarray, constructing first difference profile corresponding to each calculated summation profile, and screening the first difference profiles to choose presumptive leading and trailing edges of the fiducial.

3. A method according to Claim 2, wherein the finding step comprises, taking midpoints between presumptive leading nd trailing edges.

4. A method according to Claim 2 or 3, wherein the calculating step comprises, selecting from the two-dimen-

9

sional digitised image array, four two-dimensional subarrays located a predetermined distance on either side of the X and Y coordinates found in the finding step, determining first differences for each of the four subarrays, choosing maximum and minimum values for X and Y from the first differences from subarrays located on either side of the X and Y values, respectively, found in the finding step, and averaging chosen values for X and Y, respectively, to find exact X and Y values.

5. A method according to Claim 4 wherein the selecting step includes examining a plurality, preferably seven, rows of pixels centred about X coordinate of approximate centre, retrieving pixel data along each row from 0.75 to 1.25 times the fiducial radius distance and from -1.25 to -0.75 times the fiducial radius distance from X, examining a plurality, preferably seven, columns of pixels centred about Y coordinate of approximate centre, and retrieving pixel data along each column from 0.75 to 1.25 times the fiducial radius distance and from -1.25 to -0.75 times the fiducial radius distance from Y.

6. A method according to Claim 4, 5 or 6, including the steps of examining four subarrays of pixel data selected as a function of their location in relation to established approximate X, Y centre coordinates, finding first differences in each subarray, and averaging maximum and minimum values in each subarray.

7. A method according to Claim 2, 3, 4, 5 or 6, wherein the screening step includes repeatedly comparing pairs of plus and minus peaks from first differences of the summation profiles to obtain candidate peak and valley pairs separated by a distance within one fourth of expected fiducial radius dimension, and picking from the candidate peak and valley pairs, one pair whose distance apart most closely matches expected fiducial diameter dimension.

8. A method of locating a fiducial centre to sub pixel accuracy, comprising the steps of finding leading and trailing edges and approximate centre coordinates through analysis of one dimensional first differences of summation profile arrays, and determining exact centre coordinates through analysis of four narrowly constrained, two dimensional pixel arrays whose locations are chosen as a function of distance from approximate centre coordinates.

9. A method according to Claim 8, wherein the finding step includes, obtaining a digitised image array of whole scene, examining a predetermined two dimensional subarray wherein the fiducial is expected, and forming one-dimensional summation profiles for rows and columns of pixels in the subarray, calculating row and column summations of pixel values in the subarray for structuring a one dimensional profile array, assuming leading edge of the fiducial to correspond to a high positive derivative and trailing edge to correspond to low negative derivative in each one-dimensional profile array, and establishing approximate X, Y centre coordinates, at points midway between the high and low derivatives.

10. A method accordig to Claim 8 or 9, wherein the determining step includes examining four subarrays of pixel data selected as a function of their location in relation to established approximate X, Y centre coordinates, finding first differences in each subarray, and averaging maximum and minimum values in each subarray.

11. A method of precisely locating an object in a field of view, comprising the steps of obtaining a digitised image array of whole scene, examining a predetermined two dimensional subarray wherein object is expected, and forming one dimensional summation profiles for rows and columns of pixels in the subarray.

12. A method according to Claim 11, wherein said forming step includes calculating row summations of pixel values in the subarray for structuring a one-dimensional profile array, and calculating column summations of pixel values in the subarray for structuring a one-dimensional profile array.

13. A method according to Claim 12, including assuming leading edge of the object to correspond to a high positive derivative and trailing edge to correspond to low negative derivative in each one-dimensional profile array, and establishing approximate X, Y centre coordinates, at points midway between the high and low derivatives.

14. A method according to Claim 12 or 13, wherein the calculating step comprises establishing two pairs of concentric bounding arcs about coordinates of approximate centre as a function of distance therefrom, finding first differences in pixel data within the concentric bounding arcs, and averaging maximum and minimum first difference values within concentric bounding arc pairs.

15. A method according to Claim 11, 12, 13 or 14, examining four subarrays of pixel data selected as a function of their location in relation to established approximate X, Y centre coordinates, finding first differences in each subarray, and averaging maximum and minimum values in each subarray.

**FIG. 1**

**FIG. 2**

DERIVATIVE ⟶ LEADING EDGE

SUMMATION

42    56    50

**FIG. 3**

TRAILING EDGE

Y PROFILE

23000

22000

21000

20000

0          50         100        150        200

COLUMN SUMS IN SEARCH WINDOW

**FIG. 4**

FIG. 5

FIG. 6

ENTER — 100

OBTAIN SUMMATION
PROFILES IN
X & Y DIRECTIONS — 102

FIND FIRST
DIFFERENCES — 104

FIND PEAK-VALLEY
PAIRS FITTING
FIDUCIAL DIAMETER — 106

108
ONE BEST FIT — N → ERROR

Y

APPROXIMATE CENTER
1/2 WAY BETWEEN — 110

112
CENTER
X & Y FOUND
? — N → ERROR

Y

ESTABLISH
BOUNDING ARCS — 114

116 — RETRIEVE PIXEL DATA
FOR 7 ROWS/COLS IN
BOUNDING AREA

118 — FIND FIRST
DIFFERENCES
OF PIXEL DATA

120 — FIND EDGE
COORDINATES

122 — FIND CENTERS OF
EACH ROW/COL

124 — AVERAGE ROW CTRS
AND COL CTRS

126 — RETURN

FIG. 7

16